(19)

Europäisches
Patentamt
European
Patent Office
Office européen
des brevets

(11)  EP 2 133 928 A2

(12)  **EUROPEAN PATENT APPLICATION**

(43) Date of publication:
  **16.12.2009  Bulletin 2009/51**

(51) Int Cl.:
  **H01L 31/052** (2006.01)

(21) Application number: **09162442.9**

(22) Date of filing: **10.06.2009**

| | |
|---|---|
| (84) Designated Contracting States:<br>**AT BE BG CH CY CZ DE DK EE ES FI FR GB GR HR HU IE IS IT LI LT LU LV MC MK MT NL NO PL PT RO SE SI SK TR**<br><br>(30) Priority: **13.06.2008  US 139076**<br><br>(71) Applicant: **General Electric Company**<br>  **Schenectady, NY 12345 (US)** | (72) Inventor: **Meyers, Mark Marshall**<br>  **Mechanicville, NY 12118 (US)**<br><br>(74) Representative: **Bedford, Grant Richard**<br>  **GE International Inc.**<br>  **Global Patent Operation - Europe**<br>  **15 John Adam street**<br>  **London WC2N 6LU (GB)** |

(54)  **Reflective Light Concentrator**

(57)  A system 100 for generating electricity is disclosed. The system for generating electricity includes a reflector component including two decentered reflective members 102,108 disposed in a symmetric relationship relative to an optical axis 128, wherein each of the two decentered reflective members is a segment of a cylinder, and a photovoltaic cell 130 disposed coincident with the optical axis 128. A system including a plurality of electricity generating systems is also disclosed.

FIG. 1

**Description**

The invention relates generally to the area of light energy capture systems. More specifically, the invention relates to systems for collecting light energy from a source that may be in motion, such as the sun, and concentrating this light energy via techniques including reflection.

Photovoltaics is a technology and field of study that aims to develop devices, known as photovoltaic cells, that include one or more "photosensitive" surfaces and have the ability to convert light energy incident on these photosensitive surfaces into electrical energy. The light energy may for instance be solar light energy. Environmental considerations are a primary motivating factor for the drive to deploy photovoltaic cells. Several of the current electricity generating technologies, such as those which employ coal burning, have a large carbon and/or sulphur emission, or "footprint." The carbon and/or sulphur released into the environment due the use of such technologies may have harmful consequences for the environment, such as acid rain. The total amount of solar light energy available annually at earth is ~$10^{24}$ Joules. To compare, the total energy consumed by man-made activities in the year 2007 was ~$10^{20}$ Joules. It is clear that capturing even a fraction of the available solar light energy to produce electricity may help to mitigate present and future electrical energy needs.

Photovoltaic cells are sometimes referred to as solar cells when the source of the light energy utilized by them is the sun. To generate electrical energy in useful quantities, arrays of these solar cells, sometimes referred to as solar or photovoltaic arrays, may need to be deployed. Semiconductors, such as silicon, are useful materials that may be used to fabricate individual photovoltaic cells. Other semiconductor materials that can be used to fabricate photovoltaic cells include gallium arsenide and germanium, among others.

There are several factors, often interrelated, that determine the final cost of electrical energy as produced by a photovoltaic array. Typically, the cost of the photovoltaic cells is a significant fraction of the cost of a photovoltaic array. The efficiency of any individual photovoltaic cell also affects the cost of the final deployed photovoltaic array, as the amount of electrical energy produced from a given amount of light energy determines how many photovoltaic cells need be deployed to produce a required amount of electrical energy.

The efficiency with which a photovoltaic cell is able to convert incident light energy into electrical energy is a function of several factors. One of the factors is the intensity of light energy incident on a photosensitive surface of a photovoltaic cell. In general, for a given set of operating conditions, the efficiency of a photovoltaic cell increases with an increase in the intensity of light energy incident on its photosensitive surface

One possible scheme therefore, to reduce the cost per unit electrical energy produced by an individual photovoltaic cell, is to increase the intensity of, i.e., concentrate, the light energy incident on the photosensitive surface of the photovoltaic cell. This may result in cost savings due to the increased efficiency of the light-energy-to-electrical-energy conversion process. In addition the use of concentration leads to a reduction in the amount of photosensitive surface area required to produce a given amount of electricity (electrical energy). Typically, the per unit area cost of a reflector component that aids in the concentration of light energy is significantly less than the per unit surface area cost of the photosensitive surface of a photovoltaic cell (about 1/10th to about 1/5th), and therefore, employing concentrators results in a further cost reduction.

An increase in the intensity of the light energy incident on any photosensitive surface, such as the photosensitive surface of a photovoltaic cell, may be achieved via a light energy concentrating system. Such systems enable the concentration of light energy captured over a given surface area onto a smaller surface area. These systems may be included as part of a photovoltaic array to increase the efficiency of the photovoltaic array. Typical levels of concentration of light energy achieved by currently known untracked light energy concentrating systems are about 2x.

When the source of light energy is moving relative to the photovoltaic cell, such as when the source of light energy is the sun, photovoltaic arrays, composed of modules having concentration levels greater than 5x, traditionally have been equipped with additional systems, usually electro-mechanical, that "track" the moving light source to maximize the amount of light energy captured during a day and over the course of a year. Such tracking systems ensure that the photovoltaic array points directly at the moving light source to maximize its ability to capture the available light energy. It is clear that each additional system, such as, a tracking system, that is included with the photovoltaic array adds to the cost of deployment and maintenance of the final photovoltaic array system.

A photovoltaic system that reduces the photosensitive surface area of photovoltaic cells required to produce a given amount of electrical energy, and that does not require additional systems for tracking a moving light source, would therefore be highly desirable.

Various embodiments of the present invention address these and other needs.

In accordance with one exemplary embodiment of the invention, a system for generating electricity is disclosed. The system for generating electricity includes a reflector component including two decentered reflective members disposed in a symmetric relationship relative to an optical axis, wherein each of the two decentered reflective members is a segment of a cylinder, and a photovoltaic cell disposed coincident with the optical axis.

In accordance with another exemplary embodiment of the invention, a system including a plurality of electricity generating systems is disclosed, wherein each electricity generating system comprises a reflector component including two decentered reflective members disposed in a symmetric relationship relative to an optical axis, wherein each of the two decentered reflective members is a segment of a cylinder, and a bifacial photovoltaic cell disposed coincident with the optical axis.

Various advantages and features will be more readily understood from the following detailed description of preferred embodiments of the invention that is provided in connection with the accompanying drawings, in which:

FIG. 1 is a schematic of a cross-section view of a reflective light concentrator in accordance with an exemplary embodiment of the invention.

FIG. 2 is a schematic diagram showing an array of reflective light concentrators, in accordance with an exemplary embodiment of the invention.

In the following description, whenever a particular aspect or feature of an embodiment of the invention is said to comprise or consist of at least one element of a group and combinations thereof, it is understood that the aspect or feature may comprise or consist of any of the elements of the group, either individually or in combination with any of the other elements of that group.

As used herein, the word "optical axis," when used in the context of discussion of a reflective light concentrator, refers to an axis of symmetry of the reflective light concentrator.

As used herein, the word "decentered," when used in the context of discussion of a reflective light concentrator, refers to the fact that a mechanical center of the decentered reflective member is not on the optical axis of the reflective light concentrator. In similar vein, as used herein, the word "centered," when used in the context of discussion of a reflective light concentrator, refers to the fact that the mechanical center of each of the two decentered reflective members is on the optical axis of the reflective light concentrator.

As used herein, the term "profile," when used in the context of discussion of a reflective member of a reflective light concentrator, refers to the shape of a cross-section of the reflective member. For instance, the "profile" of a cross-section of a cylinder is referred to as "cylindrical".

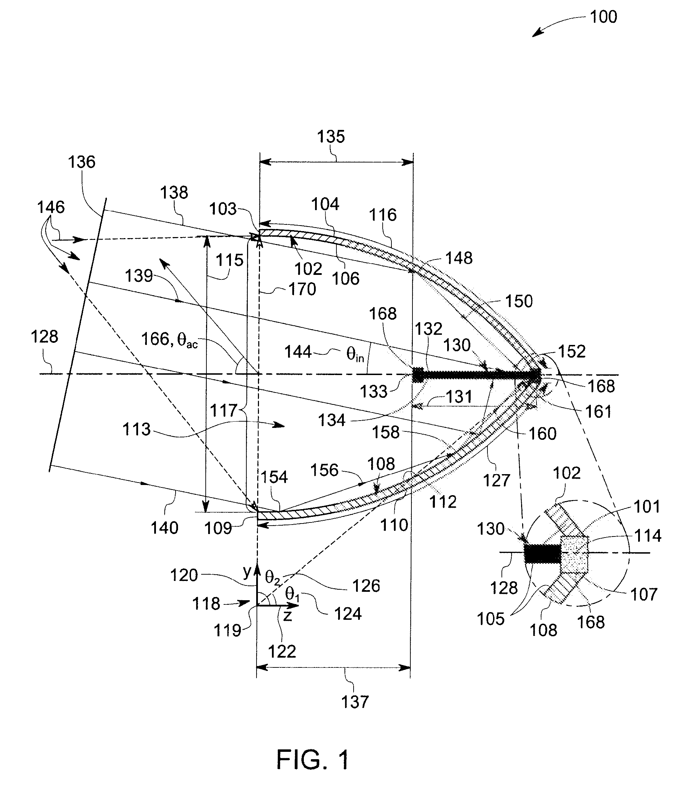

Embodiments of the invention, such as the exemplary embodiment shown in FIG. 1, include a system 100 for generating electricity, including a reflector component 105 including two decentered reflective members 102 and 108 disposed in a symmetric relationship relative to an optical axis 128, wherein each of the decentered reflective members 102 and 108 have a spheric profile and is a segment of a cylinder, and a photovoltaic cell 130 disposed coincident with the optical axis 128. A first reflective member 102 extends from a first proximal end 101 to a first distal end 103, and has a first outer interface 104 and a first inner reflective interface 106. The first outer interface 104 can be reflective or non-reflective. For example, the first outer interface 104 will be reflective if there is present a reflective surface, such as a coating of a metal, along this interface. The illustrated embodiment further includes a second reflective member 108, that extends from a second proximal end 107 to the second distal end 109, and has a second outer interface 110 and a second inner reflective interface 112. It is pointed out that the first reflective member 102 and the second reflective member 108 are "decentered". The first reflective member 102 and the second reflective member 108 together form a reflector component of the illustrated embodiment of the system 100. This is in contrast to the traditional light concentrator systems known in the art, such as for instance hemispherical cylindrical reflectors, which are "centered." The first inner reflective interface 106 and the second inner reflective interface 112 delineate a boundary of a volume 113 that is enclosed within the illustrated embodiment of the system 100. The first distal end 103 of the first reflective member 102 and the second distal end 109 of the second reflective member 108 define a width 115 of the front aperture 117. The illustrated embodiment further includes a metal strip 168 (discussed below). As shown, this metal strip lies between the first proximal end 101 and the second proximal end 107 of the first reflective member 102 and the second reflective member 108 respectively. A vertex 114 can be defined as the edge (in this case "virtual") along which the first proximal end 101 and the second proximal end 107 could have met, had the metal strip 168 been absent, and the profiles of the first reflective member 102 and the second reflective member 108 had been continued towards each other. In the illustrated embodiment then, the first reflective member 102 and the second reflective member 108 form a decentered reflective light concentrator.

Embodiments of the invention allow for the reflection of light energy rays that are incident over a first area, $A_1$, onto a second area, $A_2$. One may define a dimensionless ratio C, such that:

$$C = \frac{A_1}{A_2} \qquad (1)$$

Embodiments of the invention have values of "C" lying within the range, $2.0 < C \leq 5$.

If the first area $A_1$ is larger than the second area $A_2$, then the intensity of light energy rays incident on the second area $A_2$ is greater than the intensity of light energy rays incident on the first area $A_1$. This amounts effectively to a "concentration" of light energy rays that were collected over first area $A_1$, onto second area $A_2$. Embodiments of the invention include reflective members, and a bifacial photovoltaic cell arranged so that light energy rays incident on the reflective members, are reflected and concentrated onto the photosensitive surface of the photovoltaic cell. Embodiments of the invention are able to reflect incident ("collected") light energy rays onto an area that is about 2 times to about 5 times smaller than the area over which the light energy rays were collected. Because each of the reflective members 102 and 108 are individually segments of a cylinder, their profiles are termed "spheric." However, it is known in the art that surfaces having aspheric profiles allow for enhanced levels of aberration correction and therefore allow for higher levels of concentration, as compared to surfaces having spheric profiles.

The trajectory of motion of the sun across the earth's sky during the course of a day and during the course of a year, relative to any particular location on the earth, is well known. In particular, it is also well known that the sun moves from east to west in the earth's sky. Also, it is well known, that the maximum possible seasonal variation in altitude is about +/- 23.5°. Embodiments of the present invention are adapted to apply these principles in a way to accommodate the motion of the sun and still allow for significant light concentration without loss of collection efficiency, and without necessarily employing a solar tracking system.

Traditionally, solar light energy concentrator systems have included additional tracking systems to enhance light collection ability. The profiles of such solar light energy concentrators as are known in the art may broadly be classified as "centered" profiles, in the sense that for these profiles, the geometrical center and the optical center of the reflective light concentrator are coincident. Another way of saying this is that the profile of the solar light energy concentrator forms a mathematically "continuous" curve with uniquely definable tangents at each location on the profile (shape). Such systems have typically enabled light concentration ratios C of about 2. On the other hand, compound parabolic troughs that include two "decentered" parabolic segments are also well known in the art. However, the difficulty and cost of fabricating these compound parabolic troughs is generally greater than the difficulty and cost of fabricating decentered reflective members that are segments of cylinders.

Various embodiments of the invention are capable of concentrating light energy for all values of physical dimensions that satisfy the following mathematical criterion, expressed in terms of the focal length FL of the reflective member, which is a segment of a cylinder, and a width W of the front aperture 115: $0.25 \leq FL/W \leq 1$. It is pointed out that the focal length of the reflective member is expressible in terms of the radius of curvature R of the reflective member according to the well-known relation $FL = R/2$. The radius of curvature R is indicated in FIG. 1 via reference numeral 170.

As has been mentioned, certain embodiments of the invention include at least one reflective member. The mathematical relationship used to realize a profile (referred to as "Sag" in the formula below) of any such reflective member is given by:

$$\mathrm{Sag}\,(y) \equiv \frac{cv \cdot y^2}{1 + \sqrt{1 - (1 + \kappa) \cdot cv^2 \cdot y^2}} + (AD \cdot y^4 + AE \cdot y^6 + AF \cdot y^8 + AG \cdot y^{10}) \qquad (2)$$

The parameter "cv" represents a curvature of the reflective member that is the inverse of the mechanical radius R of the reflective member. The parameter "k" represents a conic constant. The conic constant can assume a multitude of values, which determine the profile of the reflective member. For instance, if the conic constant equals -1, then the formula (2) generates a parabola. Similarly if the conic constant equals zero, then the formula (2) generates a sphere, and so on. In embodiments of the present invention, this parameter may be in a range $-1 < \kappa \leq 0$. In formula (2), above, "y" represents a distance from a reference point to the inner reflective interface surface (discussed below) of the reflector. Here, "AD" represents a fourth order aspheric coefficient, "AE" represents a sixth order aspheric coefficient, "AF" represents a eighth order aspheric coefficient, and, "AG" represents a tenth order aspheric coefficient. Different orders of aspheric profiles may be realized based on the choice of terms included in the above formula (2). For instance, if one retains only the first term, as is listed in the right hand side of formula (2), one obtains a cylindrical profile, which is a zeroth order aspheric profile, i.e., it is a 1-dimensional spheric profile. Inclusion of additional terms in the formula (2) allows one to realize profiles of increasing orders of asphericity.

A spatial extent 116 of the first reflective member 102 may be defined according to several equivalent methods, which would be known to one skilled in the art. One possible method of defining the spatial extent of a reflective member is illustrated by considering, for instance, the first reflective member 102 as shown in FIG. 1. One may construct a first coordinate system 118 at reference point 119, having an ordinate, denoted as the "y"-axis, 120 and an abscissa 122, denoted as the "z"-axis. One may now define a start angle 124, denoted as $\theta_1$ in the figure, and a stop angle 126, denoted

as $\theta_2$ in the figure. One may now define the spatial extent 116 of the first reflective member, by choosing different values of $\theta_1$ and $\theta_2$ for the start angle 124 and stop angle 126 respectively. The profile and extent 127 of the second reflective member 108 may independently be defined following a procedure similar to the procedure as has been outlined above via an example of the first reflective member 102.

Consider now, as a non-limiting example, the first reflective member 102 of the embodiment of the system 100 illustrated in FIG. 1. If one were to generate the profile of this first reflective member 102 according to formula (2) by retaining just the first term on the right hand side, i.e., the term that scales as "$y^2$," the thus defined profile of the first reflective member 102 will be the "shape" of the curved surface of a cylinder and is accordingly referred to as "cylindrical." Accordingly, the first reflective member 102, having a spatial extent 116 may be referred to as "a segment of a cylinder." More generally, one may generate a different profile of the first reflective member 102 by retaining a different combination of the terms on the right hand side of formula (2). To this end, if one retains, in addition to the first term on the right hand side of formula (2) any or all of the other terms in the right hand side of formula (2), then the profile thus generated is referred to as "acylindrical."

The illustrated embodiment of the system 100 further includes an optical axis 128, which in this case is a central symmetry axis. The two reflective members, namely the first reflective member 102, and the second reflective member 108, are arranged symmetrically about this optical axis 128.

The illustrated embodiment of the system 100 further includes a photovoltaic cell 130. Photovoltaic cell 130 in some embodiments is a bifacial photovoltaic cell, meaning that the photovoltaic cell has the capability of absorbing electromagnetic radiation energy (contained, for instance, in light energy rays), and generating electrical current using that electromagnetic radiation, on at least two photosensitive surfaces. Photovoltaic cell 130 as illustrated in the exemplary embodiment of the system100 has a spatial extent 131, a first photosensitive surface 132, and a second photosensitive surface 134. It is also pointed out that embodiments of the invention can include one or more photovoltaic cells, wherein each includes a single photosensitive surface. Semiconductors, such as for instance, silicon, are useful materials that may be used to fabricate individual photovoltaic cells. Other semiconductor materials that can be used to fabricate photovoltaic cells include, gallium arsenide, and germanium, copper indium gallium sulfide, gallium indium sulphide, and combinations thereof.

In an exemplary embodiment of the invention, the choice of the one or more materials from which the photovoltaic cell 130 is composed may be made so that the photovoltaic cell 130 is transparent to certain wavelengths of incident light energy rays. As a non-limiting example, it is well known in the art that photovoltaic cells may be composed of silicon and that silicon has a high transmission coefficient for light energy rays having wavelengths above about 1100 nanometer (nm). Since this light energy with wavelengths above 1100 nm is not utilizable to generate electricity (electrical energy), it serves to heat up the photovoltaic module, and it is therefore desirable to reflect this light energy out of the photovoltaic module. This scheme of reflecting out at least a portion of the infra-red light energy rays will mitigate issues related to heating, i.e., a rise in temperature, of the reflective light concentrator and more generally of the photovoltaic array. It is known in the art that the light energy to electrical energy conversion efficiency of the photovoltaic cell has an inverse relationship with the temperature of the photovoltaic cell. Therefore, mitigating heating issues as described above may result in a reduction of cost of the electrical energy production.

Another useful quantity, a first z-offset 135, is defined as the distance, along the z-direction, from the first distal end 103 to a point 133 on the photovoltaic cell 130 that is at the front aperture 117 end of the photovoltaic cell 130 along the z-axis from the vertex 114 end of the photovoltaic cell 130. In a preferred embodiment, the value of z-offset is so that, $0.25\ FL \le z\text{-offset} \le FL$.

It should be noted that, although in the illustrated embodiment of the system 100 both the first reflective member 102 and the second reflective member 108 are shown as being substantially similar in profile and spatial extent, this need not be the case, i.e., the profile and spatial extent of each of the reflective members can be defined independently of each other. If the profile and spatial extent of the second reflective members 108 are indeed defined independently of the first reflective member 102, then another useful quantity, a second z-offset 137, may be defined as the distance, along the z-direction, from the second distal end 109 to a point 133 on the photovoltaic cell 130 that is at the front aperture 117 end of the photovoltaic cell 130 along the z-axis from the vertex 114 end of the photovoltaic cell 130.

Referring again to FIG. 1, the two reflective members 102 and 108 may individually be composed of metals including aluminum, silver, and combinations thereof.

Referring again to FIG. 1, at least one of the reflective interfaces, viz., the first outer interface 104, the first inner reflective interface 106, the second outer interface 110, and the second inner reflective interface 112, are capable of reflecting incident light energy rays. In some embodiments a coating composed of one or more suitable materials is disposed at any of these reflective interfaces to, for example, enhance said reflection ability and/or to protect the reflective interfaces from exposure to the environment, among other reasons. Such coatings may endow additional reflecting properties to the reflecting interfaces, such as, for example, ability to selectively reflect certain wavelengths of incident light energy ray flux 136, and/or ability to selectively absorb certain wavelengths of incident light energy ray flux 136. In certain embodiments, said "reflective coatings" include multi-layer dielectric films. Other suitable materials from which such reflective coatings may be composed include metals, including but not limited to, aluminum, silver, gold, stainless steel, and combinations thereof. Further, suitable materials from which said "protective coatings" may be composed include, but are not limited to, silicon oxide, silicon dioxide, and combinations thereof.

Volume 113 may be filled or partially filled with ambient air, or, in some embodiments, a dielectric material, so long as such "filler" material is substantially transparent to a desired portion of the incident radiation. Suitable choices of such filler materials include, but are not limited to, plastics, epoxy, silicone, glass, oils, and combinations thereof.

Light energy ray flux 136, containing for example, light energy rays 138, and 140, and traveling in direction 139, is incident at an angle 144 to the optical axis 128, denoted as $\theta_{in}$. It is emphasized that, even though the light energy ray flux 136 is shown in FIG. 1 as traveling substantially in the same direction 139 into the volume 113, this need not be the case, i.e., the light energy ray flux 136 into the volume 113 can contain light energy rays traveling in different directions, denoted by the group of arrows 146. The light energy rays 146 are representative of diffuse light energy rays as are encountered when, for instance, clouds, haze or humidity are present in the atmosphere. Consider now, as an example, the light energy ray 138 that is incident at an angle of $\theta_{in}$ to the optical axis 128 into the volume 113. The light energy ray 138 upon entering the volume 113 is incident on to the first inner reflective interface 106 at location 148. Following the laws of reflection, which would be known to one skilled in the art, the light energy ray 138 is reflected and now travels in a direction 150, that is different from the direction 139, onto a location 152 on the first photosensitive surface 132 of the bifacial photovoltaic cell 130. Although the path of the light energy ray 138 within the volume 113 contains only a single reflection event (that takes place at location 148 of the first inner reflective interface 106 of the first reflective member 102), this need not be the case, and a light energy ray traveling into the volume 113 may undergo zero reflection, or more than one reflection event before it finally reaches the first photosensitive surface 132 or the second photosensitive surface 134 of the bifacial photovoltaic cell 130. This is illustrated, by considering for example, the light energy ray 140, which undergoes a first reflection event at location 154 on the second inner reflective interface 112 of the second reflective member 108 and travels hence in a direction 156 that is different than its earlier direction 139, to eventually undergo a second reflection event at location 158 on the second inner reflective interface 112 to travel hence along a direction 160 to ultimately impinge on the second photosensitive surface 134 of the photovoltaic cell 130 at location 161. The profile of the first reflective member 102, the profile of the second reflective member 108, the spatial extent 116 of the first reflective member 102, the spatial extent of the second reflective member 108 and the spatial extent of a photovoltaic cell 131, amongst other parameters, are parameters that determine the concentration of light energy as per formula (1) that can be achieved.

From the preceding descriptions, it will be apparent that the choice of the start angle 124, and/or stop angle 126, and/or the spatial extent 131 of the photovoltaic cell, and/or the particular profile of the first reflective member 102 as generated via a choice of the terms retained on the right hand side of formula (2), and/or the particular profile of the first reflective member 108 as generated via a choice of the terms retained on the right hand side of formula (2), may change the proportion of the incident light that is reflected onto the photosensitive surfaces of the bifacial photovoltaic cell 130.

In the embodiment illustrated in FIG. 1 is further shown an acceptance angle 166 denoted as $\theta_{ac}$. This angle represents the maximum angle over which the light energy rays can be collected by the embodiment and reflected on to the photovoltaic cell 130. For the illustrated embodiment, $\theta_{ac}$ is about +/- 27.5°. It is likely that different choices of the spatial extent 116 of the first reflective member 102, the spatial extent 127 of the second reflective member 108, the profile of the first reflective member, and the profile of the second reflective member, may result in different values for $\theta_{ac}$. Different reflectors can allow for larger acceptance angles. It is noted that there normally is a trade-off between concentration ratio "C," and the range of acceptance angles $\theta_{ac}$ over which the reflective light concentrator system can collect light energy. Typically, reflective concentrator systems with higher concentration ratios have a reduced ability to collect diffuse light over a large angular variation in the position of the sun in the sky. As the figure illustrates, a substantial portion of the incident radiation from within the acceptance angle 166 about the optical axis 128, is captured and concentrated at the photovoltaic cell 130.

Various embodiments of the invention may include a heat transfer system that is in thermal communication with a heat sink. As is well known in the art, a portion of the energy contained within the light energy rays that are incident on the photovoltaic cell 130 will be dissipated as heat energy within the photovoltaic cell 130. This may lead to heating of the photovoltaic module, and in particular of the photovoltaic cell 130. The consequent rise in the temperature of the photovoltaic cell 130 in turn may result in a decrease in the light-energy-to-electrical-energy conversion efficiency of the photovoltaic cell 130. Over a period of time, the heating may even result in physical damage of the photovoltaic cell 130. In one non-limiting example, as shown in FIG. 1, the heat transfer system may include a metal strip 168 disposed along the perimeter of the photovoltaic cell, and in thermal communication with the photovoltaic cell. In this example, the heat transfer system may facilitate the transference of heat from the photovoltaic cell. The heat transfer system may be a system that is dedicated solely for its purpose, or it could serve additional purposes such as providing mechanical support within/to the photovoltaic array. Moreover, in some instances the heat transfer system may be "distributed," in the sense that other components (present at different locations) and/or features of the photovoltaic array may also serve to mitigate heating related issues. For example, in the embodiment shown in FIG. 1, the issues related to heating are mitigated not just by the metal strip 168, but also by the very design of the photovoltaic module, whereby at least a portion of the infrared light energy, which causes heating, is reflected out of the photovoltaic module.

In the embodiment illustrated in FIG. 1, the radius of curvature 170 of the first reflecting interface 102 is about 25 mm. The first and the second reflecting interfaces are offset, along the ordinate (y-axis) by an amount of about 15 mm, and along the abscissa (z-axis) by an amount of about 3 mm. The start angle 124 is about 36° and the stop angle 126 is about 90°. These dimensions, of course, are provided for illustrative purposes only and should not be construed to limiting aspects of the invention in any way.

Certain embodiments of the invention include a system including a plurality of electricity generating systems, wherein each electricity generating system includes a reflector component including two decentered reflective members disposed in a symmetric relationship relative to an optical axis 128, wherein each of the decentered reflective members is a segment of a cylinder, and a bifacial photovoltaic cell disposed coincident with the optical axis 128.

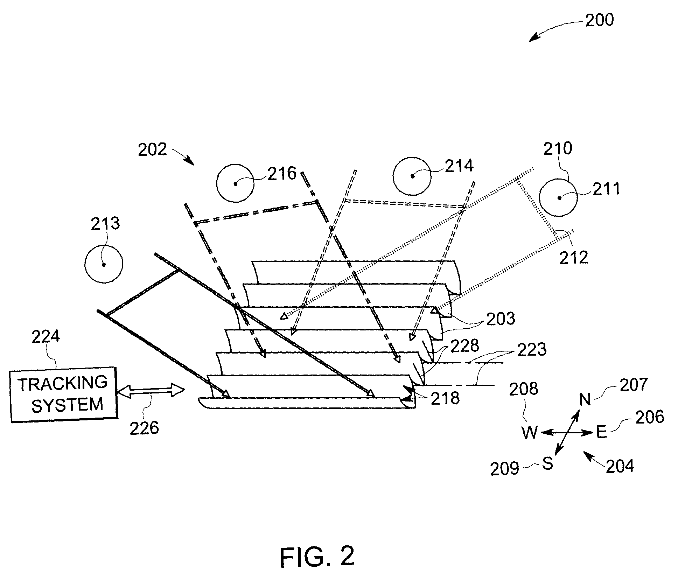

FIG. 2 shows, in schematic, a perspective view 200 of an array 202 of reflective light concentrators according to an embodiment of the invention. The array 202, which includes a plurality of reflective light concentrators 203, and bifacial photovoltaic cells 228, may be formed by placing the individual reflective light concentrators displaced relative to each other in space. An exemplary feature of certain aspects of the invention, which mitigates the need for a separate light source tracking system (to track a light source that is in motion relative to the array 202), is illustrated via this figure. Consider, as a non-limiting example, the situation in which the light source 210 is the sun. In such a situation, the individual light concentrators may be advantageously disposed so that they lie in the same plane, and may be oriented similarly in a direction substantially towards the sun, so that their individual long axes 223 (which is substantially perpendicular to their individual central symmetry axes 226) substantially parallel to each other. In certain embodiments the individual long axes 223 are aligned along the east-west 206-208 direction, and the optical axis may be aligned, with respect to the azimuthal axis (not shown), at an angle equal to the latitude angle of the particular location at which is placed the array 202. The figure further shows a cardinal direction system 204 indicating the east cardinal direction 206 and the west cardinal direction 208. The direction system 204 further indicates the north cardinal direction 207 and the south cardinal direction 209. The array 202 is oriented so that the long axes 223 are along the east-cardinal-direction-to-west-cardinal-direction line. The source 210 of light is in motion, relative to the array 202, from a location 211 that lies substantially on the east cardinal direction to a location 213 that lies substantially on the west cardinal direction, via a trajectory that includes, for example, locations 214 and 216. This source 210, even as it is moving as described herein, emits light continuously in a multitude of directions relative to the array 202. That portion of the emitted light that is not traveling substantially along the east cardinal direction or the west cardinal direction, but which is nevertheless disposed so that it is bound to be incident on the embodiment 202, is indicated by element 212. It is apparent that a substantial portion of the light 212 will be collected by the plurality of reflective light concentrators 203 of the array 202.

In the above exemplary embodiment, the profiles of each of the reflecting surfaces 218 of each of the reflective light concentrators 203 may independently be defined by retaining different terms in formula (2), and consequently the value of the ratio "C" defined as per formula (1), for each reflective light concentrator of the plurality of reflective light concentrators 203 may be different.

Although not necessary to the operation of the systems described herein, a light source tracking system, configured to individually dynamically orient the photovoltaic modules, or the photovoltaic array, to receive light emitted by a light source, may be employed in some embodiments to further ensure that maximal available light is being collected by the system. The embodiment illustrated in FIG. 2 further shows a tracking system 224 that is in electro-mechanical communication 226 with the array 202. The mechanical communication between the tracking system 224 and the array 202 might include one or more independent mechanical and/or electrical drives.

These mechanical and/or electrical drives may be disposed so as to be able to tilt the array 202 about one of more axes. For instance, the tracking system might employ drives which are able to independently tilt the array 202 about an elevation axis (not shown), and/or about an azimuthal axis (not shown).

While the invention has been described in detail in connection with only a limited number of embodiments, it should be readily understood that the invention is not limited to such disclosed embodiments. Rather, the invention can be modified to incorporate any number of variations, alterations, substitutions or equivalent arrangements not heretofore described, but which are commensurate with the spirit and scope of the invention. Additionally, while various embodiments of the invention have been described, it is to be understood that aspects of the invention may include only some of the described embodiments. Accordingly, the invention is not to be seen as limited by the foregoing description, but is only limited by the scope of the appended claims.

1. A system for generating electricity, comprising:

   a reflector component comprising:

two decentered reflective members disposed in a symmetric relationship relative to an optical axis, wherein each of the two decentered reflective members is a segment of a cylinder; and

a photovoltaic cell disposed coincident with the optical axis.

2. The system of clause 1, wherein at least one of the two decentered reflective members comprises a metal, such as aluminum, silver, and combinations thereof.

3. The system of any preceding clause, wherein the photovoltaic cell is bifacial.

4. The system of any preceding clause, wherein the reflector component comprises a protective coating, and wherein the protective coating comprises silicon oxide, silicon dioxide, and combinations thereof.

5. The system of any preceding clause, wherein the reflector component comprises a reflective coating, wherein the reflective coating comprises metals.

6. The system of any preceding clause, wherein the system further comprises a tracking system that is configured to dynamically orient the system to receive light emitted by a light source.

7. The system of any preceding clause, wherein the system further comprises a heat transfer system comprising a metal strip disposed along a perimeter of the photovoltaic cell and in thermal communication with a heat sink.

8. The system of any preceding clause, wherein the system has a long axis that is disposed along an east-west direction.

9. The system of any preceding clause, wherein a profile "Sag" of each reflective member is independently defined according to the formula:

$$\text{Sag}\,(y) \equiv \frac{cv \cdot y^2}{1 + \sqrt{1 - (1 + \kappa) \cdot cv^2 \cdot y^2}} + (AD \cdot y^4 + AE \cdot y^6 + AF \cdot y^8 + AG \cdot y^{10})$$

wherein, cv is a curvature of the reflective member, $\kappa$ is a conic constant, AD is a fourth order aspheric coefficient, AE is a sixth order aspheric coefficient, AF is a eighth order aspheric coefficient, AG is a tenth order aspheric coefficient.

10. The system of any preceding clause, wherein $\kappa$ has a value such that $-1 < \kappa \leq 0$.

11. The system of any preceding clause, wherein the physical dimensions of the reflector component are chosen so that the following mathematical condition is satisfied: $0.25 \leq FL/W \leq 1$, wherein, "FL" is a focal length of any one of the segments of the cylindrical reflective member, and "W" is a width of a front aperture.

12. A system comprising:

a plurality of electricity generating systems;

wherein each electricity generating system comprises:

a reflector component comprising:

two decentered reflective members disposed in a symmetric relationship relative to an optical axis, wherein each of the two decentered reflective members is a segment of a cylinder; and a bifacial photovoltaic cell disposed coincident with the optical axis.

13. The system of clause 12, wherein each of the plurality of electricity generating systems are arranged in space so that they lie in substantially the same plane with their individual long axes aligned substantially parallel to each other.

14. The system of clause 12 or 13, wherein the system comprises a tracking system that is configured to dynamically orient the reflector components to receive light emitted by one or more light sources.

15. The system of any of clauses 12 to 14, wherein each of the plurality of electricity generating systems are arranged in space so that they lie in substantially the same plane with their individual long-axes aligned substantially parallel to an east-west direction.

**Claims**

1. A system (100) for generating electricity, comprising:

   a reflector component (105) comprising:

      two decentered reflective members (102, 108) disposed in a symmetric relationship relative to an optical axis (128), wherein each of the two decentered reflective members (102, 108) is a segment of a cylinder; and a photovoltaic cell (130) disposed coincident with the optical axis (128).

2. The system (100) of claim 1, wherein the photovoltaic (130) cell is bifacial.

3. The system (100) of any preceding claim, wherein the system (100) further comprises a tracking system (224) that is configured to dynamically orient the system (100) to receive light emitted by a light source (210).

4. The system (100) of any preceding claim, wherein the system (100) has a long axis (223) that is disposed along an east-west (206-208) direction.

5. The system (100) of any preceding claim, wherein a profile "Sag" of each reflective member (102, 108) is independently defined according to the formula:

$$\text{Sag}(y) \equiv \frac{cv \cdot y^2}{1 + \sqrt{1 - (1 + \kappa) \cdot cv^2 \cdot y^2}} + (AD \cdot y^4 + AE \cdot y^6 + AF \cdot y^8 + AG \cdot y^{10})$$

   wherein, cv is a curvature of the reflective member (102, 108), $\kappa$ is a conic constant, AD is a fourth order aspheric coefficient, AE is a sixth order aspheric coefficient, AF is a eighth order aspheric coefficient, AG is a tenth order aspheric coefficient.

6. The system (100) of claim 5, wherein $\kappa$ has a value such that $-1 < \kappa \leq 0$.

7. The system (100) of any preceding claim, wherein the physical dimensions of the reflector component (105) are chosen so that the following mathematical condition is satisfied: $0.25 \leq FL/W \leq 1$, wherein, "FL" is a focal length of any one of the segments of the cylindrical reflective member, and "W" is a width of a front aperture.

8. A system comprising:

   a plurality of electricity generating systems;

   wherein each electricity generating system comprises:

   a reflector component (105) comprising:

      two decentered reflective members (102, 108) disposed in a symmetric relationship relative to an optical axis (128), wherein each of the two decentered reflective members (102, 108) is a segment of a cylinder; and a bifacial photovoltaic cell disposed coincident with the optical axis (128).

9.  The system of claim 8, wherein each of the plurality of electricity generating systems are arranged in space so that they lie in substantially the same plane with their individual long axes (223) aligned substantially parallel to each other.

10. The system of claim 8 or claim 9, wherein the system comprises a tracking system (224) that is configured to dynamically orient the reflector components (105) to receive light emitted by one or more light sources (210).

11. The system of any of claims 8 to 10, wherein each of the plurality of electricity generating systems are arranged in space so that they lie in substantially the same plane with their individual long-axes aligned substantially parallel to an east-west (206-208) direction.

FIG. 1

FIG. 2